# EUROPÄISCHE PATENTSCHRIFT

(11) **EP 1 097 614 B1**
(45) Veröffentlichungstag und Bekanntmachung des Hinweises auf die Patenterteilung: **23.04.2003**
(21) Anmeldenummer: 99931058.4
(22) Anmeldetag: 11.06.1999
(51) Int. Cl.: H05K 3/00, H05K 3/28

(54) **VERFAHREN ZUM BESCHICHTEN VON LEITERPLATTEN ODER DERGLEICHEN SUBSTRATEN**
METHOD FOR COATING PRINTED CIRCUIT BOARDS OR SIMILAR SUBSTRATES
PROCEDE POUR RECOUVRIR DES CARTES DE CIRCUITS OU DES SUBSTRATS SIMILAIRES

(30) Priorität: 24.06.1998 EP 98111665
(43) Veröffentlichungstag der Anmeldung: 09.05.2001
(73) Patentinhaber: Vantico AG, 4057 Basel (CH)
(72) Erfinder: WOLFER, Klaus, D-71032 Böblingen (DE); LEIBROCK, Dietmar, D-79736 Rickenbach (DE)
(74) Vertreter: Klingseisen, Franz, Dipl.-Ing.
(86) Internationale Anmeldenummer: EP9904044
(87) Internationale Veröffentlichungsnummer: WO99067978

(56) Entgegenhaltungen:
- WO-A-86/06243
- DE-A- 3 602 350
- PATENT ABSTRACTS OF JAPAN vol. 15, no. 343 (E-1106), 30. August 1991 (1991-08-30) & JP 03 132090 A (TANAKA KIKINZOKU KOGYO KK), 5. Juni 1991 (1991-06-05)
- S. CRUM: "Hole plugging with liquid photoimageable solder masks" ELECTRONIC PACKAGING AND PRODUCTION., Bd. 37, Nr. 4, März 1997 (1997-03), Seiten 51-54, XP000687295 MASSACHUSETTS US

## Beschreibung

Die Erfindung betrifft ein Verfahren zum beidseitigen Beschichten von Substraten, insbesondere Leiterplatten.

Mit einem Lötstoplack, photostrukturierbaren Dielektrika oder anderen Materialien für sequenzielle Aufbautechnik der Leiterplatte beidseitig zu beschichtende Leiterplatten weisen eine gewisse Anzahl von Bohrungen auf, von denen je nach Aufbau der Leiteranordnung einzelne Bohrungen durch Löststoplack abgedeckt und andere für die Leitungsverbindung freigehalten werden sollen ; siehe WO-A-8606243. Es ist bekannt, die Leiterplatten dadurch zu beschichten, daß die Leiterplatten durch einen Gießvorhang aus dem aufzutragenden Lack bewegt werden. Hierbei werden die Bohrungen in der Leiterplatte nur leicht von dem Gießlack überspannt, wodurch sich für die Ausbildung der Bohrungen an der fertigen Leiterplatte gute Prozeßbedingungen ergeben, weil die Überdeckung der Bohrungen leicht entfernt werden kann.

Um die für die aufzubringende Leiteranordnung nicht benötigten Bohrungen dauerhaft zu verschließen, ist es firmenintern ferner bekannt, zunächst auf einer Seite der Leiterplatte durch Gießauftrag eine Beschichtung vorzusehen, welche die Bohrungen in der Leiterplatte nur leicht mit Gießlack überspannt, worauf diese Beschichtung in einem Trocknungsschritt soweit getrocknet wird, daß auf der Beschichtung ein Siebdruck so aufgebracht werden kann, daß die nicht benötigten Bohrungen dauerhaft abgedeckt bzw. aufgefüllt werden. Nach diesem Siebdruckschritt wird die gegenüberliegende Seite der Leiterplatte mittels Gießauftrag beschichtet. Insgesamt ergibt sich dadurch ein Verfahrensablauf mit mehreren Einzelschritten, die auch einen entsprechenden apparativen Aufwand erfordern.
Der Erfindung liegt die Aufgabe zugrunde, das Beschichtungsverfahren von Leiterplatten zu vereinfachen, ohne daß sich nachteilige Einflüsse auf die Beschichtung ergeben.

Diese Aufgabe wird erfindungsgemäß im wesentlichen dadurch gelöst, daß eine Seite der Leiterplatte durch ein Beschichtungsverfahren, insbesondere durch Siebdruck, so beschichtet wird, daß die für den Leitimgsaufbau nicht benötigten Bohrungen dauerhaft überdeckt und die benötigten Bohrungen nur geringfügig überdeckt oder freigelassen werden, worauf die andere Seite der Leiterplatte durch ein Beschichtungsverfahren, insbesondere durch Vorhanggießen oder Sprayen, so beschichtet wird daß sich nur eine leichte Uberdeckung der für den Leitungsaufbau benötigten Bohrungen ergibt.

Dadurch, daß für die Beschichtung der einen Seite der Leiterplatte Siebdrucktechnik verwendet wird, können zusammen mit der aufzubringenden Beschichtung jene Bohrungen dauerhaft abgedeckt bzw. aufgefüllt werden, die für den Leitungsaufbau nicht benötigt werden, während die für den Leitungsäufbau benötigten Bohrungen nur leicht überdeckt oder freigehalten werden können. Im zweiten Schritt wird die gegenüberliegende Seite der Leiterplatte z.B. durch Gießvorhangtechnik gleichmäßig beschichtet, wodurch im weiteren Herstellungsverlauf die für den Leitungsaufbau benötigten Bohrungen leicht freigelegt werden können. Auf diese Weise werden die Vorteile des Siebdruckverfahrens mit denen der Gießvorhangtechnik bei der Beschichtung von Leiterplatten vereinigt, wobei durch das Entfallen eines Zwischenschrittes eine Vereinfachung des Beschichtungsverfahrens erreicht wird.

Ein weiterer Vorteil liegt darin, daß die beiden Seiten einer Leiterplatte unmittelbar aufeinanderfolgend beschichtet und dann gemeinsam in einem Schritt getrocknet werden können, wodurch eine weitere Vereinfachung des Verfahrens erreicht wird, mit dem Vorteil, daß die Qualität der Beschichtung durch das gleichzeitige Trocknen der beiden Seiten erhöht wird.

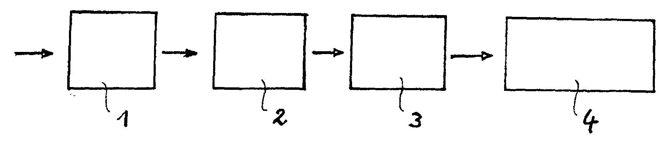

Die Erfindung wird beispielsweise anhand der Zeichnung näher erläutert, die in einer einzigen Figur schematisch den Verfahrensablauf wiedergibt.

Mit 1 ist eine erste Station bezeichnet, in der eine nicht dargestellte, mit einer gewissen Anzahl von Bohrungen versehene Leiterplatte, die ein Substrat bildet, auf einer Seite durch Siebdruck mit der aufzubringenden Beschichtung bzw. mit Lötstoplack so beschichtet wird, daß die für den Leitungsaufbau nicht benötigten Bohrungen dauerhaft überdeckt werden, während die an der fertigen Leiterplatte freiliegenden Bohrungen freigelassen oder durch das Siebdruckverfahren nur geringfügig überdeckt werden, so daß ein nachträgliches Freilegen keinen großen Aufwand bedeutet. Die dauerhaft zu verschließenden Bohrungen können bei dem Siebdruckverfahren mit dem Beschichtungsmaterial aufgefüllt werden, so daß sich ein Pfropfen in den Bohrungen ergibt, der durch die nachfolgenden Behandlungsschritte zum Freilegen leicht überdeckter Bohrungen nicht beeinträchtigt wird bzw. nicht zu einem Freilegen der Bohrung führt.

Mit 2 ist eine Wendestation bezeichnet, in die eine durch Siebdruck auf einer Seite beschichtete Leiterplatte überführt und dort gewendet wird , worauf sie in eine zweite Beschichtungsstation 3 überführt wird, in der die andere Seite der Leiterplatte mittels Vorhanggießen oder auch durch Sprayen so beschichtet wird, daß die gesamte Fläche der Leiterplatte gleichmäßig beschichtet wird und die Bohrungen in der Leiterplatte leicht überdeckt werden, so daß sich für die nachfolgende Behandlung der Leiterplatte zum Freilegen der für den Leitungsaufbau benötigten Bohrungen günstige Bedingungen ergeben.

Die Leiterplatten werden in an sich bekannter Weise derart beschichtet, daß die Ränder der Leiterplatte freibleiben und die Leiterplatten an den beschichtungsfreien Rändern durch Klammern oder dergleichen Elemente gehalten werden können, die auf einer verstellbaren Stange angeordnet sein können. Vorzugsweise wird diese Halteeinrichtung für die Leiterplatten zusammen mit diesen durch die einzelnen Stationen bewegt.

In der Wendestation 2 kann auch ein Ablüften der beschichteten Seite während des Wendevorgangs erfolgen, es wird aber bei dem geschilderten Verfahrensablauf keine Trocknung vorgesehen.

Nach dem Beschichten der zweiten Seite der Leiterplatte befindet sich die Beschichtung auf beiden Seiten noch in einem nassen Zustand, nachdem zwischen den Stationen 1 und 3 kein zeitaufwendiger Trocknungsvorgang zwischengeschaltet ist. Die beidseitig noch nasse Leiterplatte wird unmittelbar nach der Beschichtungsstation 3 in eine Trocknungsstation 4 überführt, in der die beiden Seiten der Leiterplatte getrocknet und gegebenenfalls gekühlt werden. Durch diese gleichzeitige Trocknung der Beschichtung auf beiden Seiten ergibt sich eine höhere Qualität der Beschichtung.

Nach dem Trocknen werden die Leiterplatten in an sich bekannter Weise weiterbehandelt,. um den Leitungsaufbau und das Freilegen der dafür benötigten Bohrungen vorzusehen.

Das beschriebene Verfahren eignet sich sowohl für dünne als auch dickere Substrate, die beidseitig beschichtet werden sollen.

Anstelle von Siebdruck kann auch eine andere Beschichtungsart vorgesehen werden, mittels der bestimmte Bohrungen mit dem Beschichtungsmaterial im wesentlichen aufgefüllt werden können, während andere Bohrungen freigehalten oder nur leicht überdeckt werden. In der gleichen Weise kann anstelle von Vorhanggießen oder Sprayen auch eine Beschichtungsart für die andere Seite des Substrats vorgesehen werden, die nur eine leichte Überdeckung der Bohrungen ergibt.

Vor allem bei dickeren und entsprechend steifen Substraten kann auch der Beschichtungsauftrag mittels Vorhanggießen oder Sprayen im ersten Schritt und das Siebdruckverfahren oder eine entsprechende Beschichtungsart mit Auffüllen von Bohrungen im zweiten Schritt ausgeführt werden.

## Patentansprüche

1. Verfahren zum beidseitigen Beschichten von Substraten, insbesondere von Leiterplatten, wobei eine Seite des mit Bohrungen versehenen Substrats durch ein Beschichtungsverfahren, insbesondere durch Siebdruck, so beschichtet wird, daß die für den Leitungsaufbau nicht benötigten Bohrungen dauerhaft überdeckt und die benötigten Bohrungen nur geringfügig überdeckt oder freigelassen werden, worauf die andere Seite des Substrats durch ein Beschichtungsverfahren, insbesondere durch Vorhanggießen oder Sprayen, so beschichtet wird, daß die gesamte Fläche des Substrats gleichmäßig mit einer Schicht versehen wird, die nur eine leichte Überdeckung der Bohrungen ergibt.

2. Verfahren nach Anspruch 1,
wobei die Beschichtung der zweiten Seite der Leiterplatte unmittelbar nach dem Beschichten der ersten Seite durchgeführt wird und die noch nasse Beschichtung der beiden Seiten gemeinsam in einer Trocknungsstation getrocknet und gegebenenfalls gekühlt wird.

3. Verfahren nach Anspruch 1,
wobei die dauerhafte Überdeckung der nicht benötigten Bohrungen in dem Substrat durch Auffüllen der Bohrungen mit dem Beschichtungsmaterial ausgebildet wird.

## Claims

1. Method of coating substrates, especially printed circuit boards, on both sides, wherein one side of the substrate, which is provided with holes, is coated by means of a coating process, especially by screen printing, in such a manner that the holes that are not required for the circuit layout are lastingly covered over and the holes that are required are covered over only slightly or are left clear, whereupon the other side of the substrate is coated by means of a coating process, especially by curtain pouring or spraying, in such a manner that the entire surface of the substrate is provided uniformly with a coating that gives only a light covering over the holes.

2. Method according to claim 1,
wherein the coating of the second side of the printed circuit board is carried out immediately after the coating of the first side and the still-wet coatings of the two sides are dried and optionally cooled together in a drying station.

3. Method according to claim 1,
wherein the lasting covering-over of the holes that are not required in the substrate is produced by filling up the holes with the coating material.

## Revendications

1. Procédé pour le recouvrement des deux faces de substrats, en particulier des cartes de circuits, dans lequel une face du substrat prévu avec des trous de forage est recouverte par un procédé de recouvrement, en particulier par sérigraphie, de sorte que pour l'établissement des circuits les trous de forage non nécessaires sont masqués durablement et les trous de forage nécessaires sont masqués superficiellement ou laissés libres, après quoi la deuxième face du substrat est recouverte par un procédé de recouvrement, en particulier par coulée à rideau ou pulvérisation, de sorte que la totalité de la surface du substrat est pourvue uniformément avec une couche qui ne produit qu'un masquage léger des trous de forage.

2. Procédé selon la revendication 1,
dans lequel le recouvrement de la deuxième face de la carte de circuits est exécuté immédiatement après le recouvrement de la première face et le recouvrement encore humide des deux faces est séché ensemble dans un poste de séchage et éventuellement refroidi.

3. Procédé selon la revendication 1,
dans lequel le masquage durable des trous de forage dans le substrat n'étant pas nécessaires se réalise par le remplissage des trous avec le matériau de recouvrement.
